Europäisches Patentamt

European Patent Office

Office européen des brevets

(11) Numéro de publication: **0 007 328**

**A1**

(12) **DEMANDE DE BREVET EUROPEEN**

(21) Numéro de dépôt: **78400066.3**

(22) Date de dépôt: **27.07.78**

(51) Int. Cl.³: **G 03 F 9/00**

(43) Date de publication de la demande:
**06.02.80 Bulletin 80/3**

(84) Etats Contractants Désignés:
**CH DE FR GB**

(71) Demandeur: **KODAK-PATHé**
**8-26, rue Villiot**
**F-75580 Paris Cedex 12(FR)**

(84) Etats Contractants Désignés:
**FR**

(71) Demandeur: **EASTMAN KODAK COMPANY**
**343 State Street**
**Rochester, New York 14650(US)**

(84) Etats Contractants Désignés:
**CH DE GB**

(72) Inventeur: **Tassou, Christian Serge Michel**
**1, avenue Florian**
**F-44800 Saint Herblain(FR)**

(74) Mandataire: **Lecas, Jean et al,**
**Kodak-Pathé 30, rue des Vignerons**
**F-94300 Vincennes(FR)**

(54) Procédé et dispositif de montage des sélections de couleur utilisées en reproduction photomécanique.

(57) Le problème à résoudre est celui de la fixation rapide des sélectons d'un même jeu (correspondant à une même image) dans des positions exactement identiques, à repérer sur des supports de montage distincts

On repère la position d'une sélection (25) sur son support (22) à l'aide d'un bras (2) qui porte des goujons propres à passer dans des trous de repérage (26) percés dans la sélection (25). On relève alors le bras et on place précisément un autre support sur la table (20), dans la position antérieurement occupée par le précédent. On rabat le bras (2) sur ce nouveau support. Les goujons reviennent alors exactement dans la position qu'ils occupaient sur le support précédent. On passe ensuite une autre sélection sur ces goujons. Celle-ci occupe alors exactement la même position que la précédent sélection, position repérée rapidement et sans tâtonnement.

./...

FIG.2

- 1 -

PROCEDE ET DISPOSITIF DE MONTAGE DES SELECTIONS DE COULEUR UTILISEES EN
REPRODUCTION PHOTOMECANIQUE.

La présente invention, due à la collaboration de Monsieur
Christian, Serge, Michel TASSOU, est relative à un procédé de montage
des sélections de couleur utilisées en reproduction photomécanique et
à un dispositif pour la mise en oeuvre de ce procédé.

Dans l'industrie des arts graphiques, la réalisation d'impressions polychromes exige la fabrication d'un jeu de plaques d'impression.
Chaque plaque est obtenue par voie photographique à partir d'un montage
de plan-films photographiques dits "négatifs" ou "positifs" de sélection,
suivant les cas. Un négatif de sélection, par exemple, est un plan-film
photographique qui, après exposition à travers un filtre coloré, puis
développement, porte une image négative de l'original à reproduire. Il
constitue un enregistrement de l'une des composantes chromatiques de
cette image, correspondant classiquement à l'une des couleurs primaires.
Ces négatifs ou positifs de sélection seront appelés dans la suite,
d'une manière générale, "sélections".

Les sélections exposées à travers un même filtre (rouge, par
exemple) sont fixées sur un support de montage commun, dans des positions
qui sont définies par une maquette. Pour une impression en quadrichromie,
on doit fixer sur quatre supports de montage différents les quatre
groupes de sélections "magenta", "bleu-vert", "jaune" et "noir", respectivement.

Il est essentiel que les montages ainsi réalisés soient parfaitement superposables, de manière que les encrages opérés dans une presse
à imprimer par les cylindres recevant les plaques d'impression correspondantes soient eux-mêmes en parfait repérage.

Suivant un procédé courant dans la technique, on obtient cette
mise en repérage en plaçant sur une table lumineuse un premier support de montage transparent, garni d'un groupe de sélections fixées sur des plages définies par une maquette. On superpose à ce support un deuxième support transparent et, en utilisant une loupe dite "compte-fil", on monte sur ce deuxième support un autre groupe de sélections de manière que celles-ci se superposent exactement à celles du groupe précédent. Ce résultat s'obtient par tâtonnements. On répète l'opération pour chaque groupe de sélections. Il est clair qu'un tel procédé de montage est long, fastidieux et que le résultat obtenu dépend beaucoup de l'habileté de l'opérateur.

Ces inconvénients sont atténués lorsqu'on utilise le procédé décrit au brevet français 1 472 090. Suivant ce procédé, on fait usage de supports de montage comportant des trous de mise en place agencés de manière que des goujons fixés sur une table de montage passent exactement dans ces trous, lorsqu'on place un tel support sur la table. En outre, les pellicules photographiques vierges qui sont utilisées pour réaliser les sélections sont elles-mêmes munies, préalablement à leur exposition, de trous de mise en place utilisés pour garantir que ces pellicules occupent des positions identiques dans l'appareil de prise de vues où elles sont exposées. On superpose alors les supports de montage sur la table, les goujons fixés à cette table passant dans les trous de repérage percés dans les supports. On forme une pile avec les sélections d'un même jeu et on passe des goujons dans les trous de repérage empilés du jeu. On place ensuite les jeux de sélections dans les positions indiquées par une maquette et on perce deux trous de repérage additionnels à travers chaque jeu ainsi qu'à travers la maquette et les supports de montage. On sépare ensuite les supports et, grâce à des goujons passés dans les trous de repérage qui viennent d'être percés, on place en position sur chaque support le groupe de sélections approprié, puis on fixe les sélections en position.

Ce dernier procédé n'est cependant pas entièrement satisfaisant car il exige des opérations additionnelles de perçage sur la table de montage. Ces opérations doivent être réalisées avec une grande précision qui ne peut être obtenue qu'à l'aide de dispositifs de perforation complexes et coûteux, tels que ceux décrits au brevet français précité et au brevet français 2 196 089.

C'est le but de la présente invention que d'établir un procédé, et de fournir un dispositif, pour le montage des sélections de couleurs utilisées en reproduction photomécanique, procédé et dispositif suivant lesquels le montage s'obtient rapidement, sans perçage de trous addition-

- 3 -

nels sur la table de montage. L'invention a aussi pour but de fournir, à cet effet, un dispositif de montage simple et de réalisation peu coûteuse.

On atteint ces buts de l'invention avec un procédé de montage des sélections de couleur utilisées en reproduction photomécanique, suivant lequel on monte chacune des sélections d'au moins un jeu de telles sélections sur un des supports de montage d'un jeu de tels supports de manière que les sélections du jeu occupent sur leurs supports respectifs des positions relatives identiques. On place une sélection sur un support, on relève avec précision la position de cette sélection sur ce support à l'aide d'un organe de repérage, on remplace le support par un autre qu'on fixe avec précision dans la position occupée par le précédent, on matérialise sur cet autre support la position relevée, grâce à cet organe, et on monte une autre sélection du même jeu sur ce support, dans la position matérialisée par l'organe de repérage.

Pour la mise en oeuvre de ce procédé, l'invention fournit un dispositif qui comprend (1) au moins un organe de repérage conçu pour coopérer avec une sélection de couleur de manière à repérer sa position et (2) un mécanisme pour supporter cet organe avec deux degrés de liberté dans le plan d'un support de montage propre à recevoir la sélection et pour conserver la position de l'organe de repérage lorsque celui-ci coopère avec une sélection de couleur.

Grâce à cet organe de repérage, on détermine instantanément la position dans laquelle une sélection de couleur doit être fixée. En outre, ce résultat est obtenu sans perçage de trous de repérage additionnels.

D'autres avantages apportés par la présente invention apparaîtront à l'examen de la description qui va suivre et du dessin annexé, donné seulement à titre d'exemple, dans lequel :

- la figure 1 représente un mode de réalisation du dispositif suivant l'invention et,

- la figure 2 illustre une mise en oeuvre du procédé suivant l'invention, à l'aide du dispositif de la figure 1.

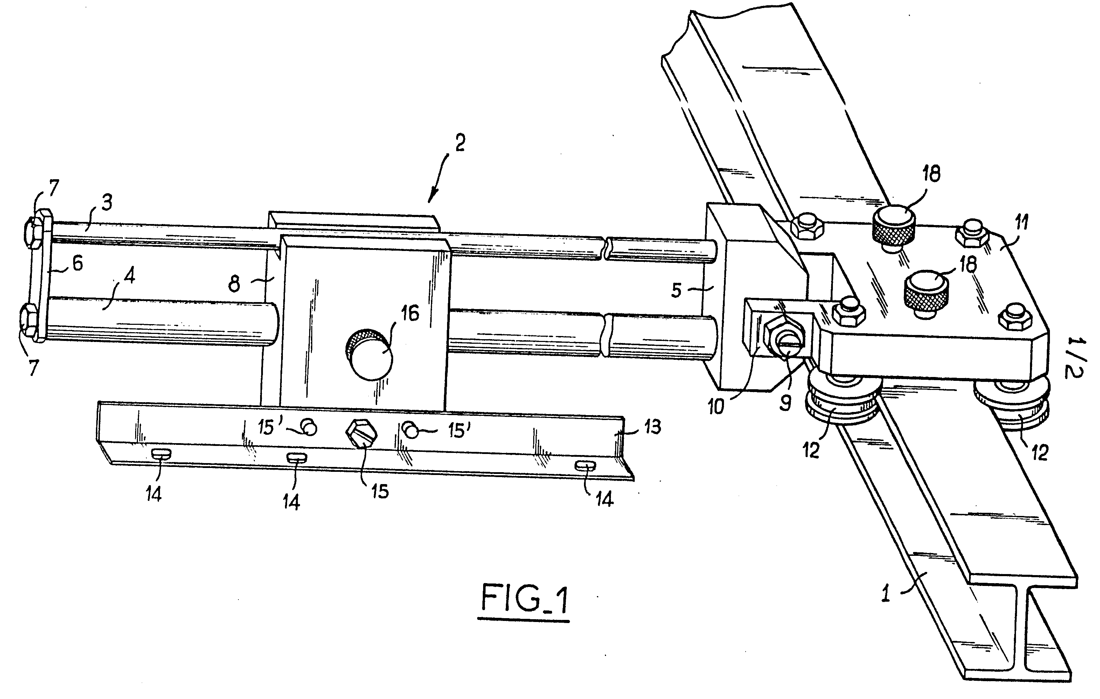

On se réfère à la figure 1 où le dispositif représenté comprend essentiellement un mécanisme constitué d'un rail 1 à section en I et d'un bras 2 défini par deux barres de guidage parallèles 3 et 4 (partiellement représentées). Ces deux barres sont fixées dans une embase pivotante 5. Une entretoise 6 réunie les extrémités de ces barres qui sont opposées à celles qui sont fixées dans l'embase 5. Des écrous 7 fixent l'entretoise 6 sur ces barres dont les extrémités sont filetées. Un bloc coulissant 8 est monté sur les barres 3 et 4, de manière qu'un opérateur puisse le faire glisser manuellement sur ces barres. L'embase 5 est montée à rotation autour d'un axe d'articulation 9 pour rendre le bras 2 mobile autour de cet axe, dans un plan perpendiculaire au rail 1. L'axe est porté par deux oreilles 10 (une seule d'entre elle étant visible sur la figure 1). Ces oreilles débordent d'une pièce mobile 11 qui peut rouler librement sur le rail 1 grâce à quatre roulettes 12, dont deux sont visibles sur la figure 1. Ces roulettes sont montées à rotation sur des axes fixés dans la pièce mobile 11. Deux molettes de blocage à vis 18 permettent de bloquer la pièce mobile 11 sur le rail 1.

Le bloc coulissant 8 porte un organe de repérage tel qu'une barrette 13 à section en "L". Cette barrette porte un certain nombre de goujons de repérage 14. Dans le mode de réalisation décrit de l'invention, on utilise une barrette Kodak de repérage à goujons, vendue en France par la demanderesse. Cette barrette est fixée au bloc 8 grâce à une vis 15 et des tétons de centrage 15' plantés dans le bloc 8 de manière à passer dans des perforations correspondantes de la barrette 13. Une molette 16 permet de bloquer l'ensemble bloc 8-barrette 13 dans une position particulière choisie, sur la barre de guidage 4.

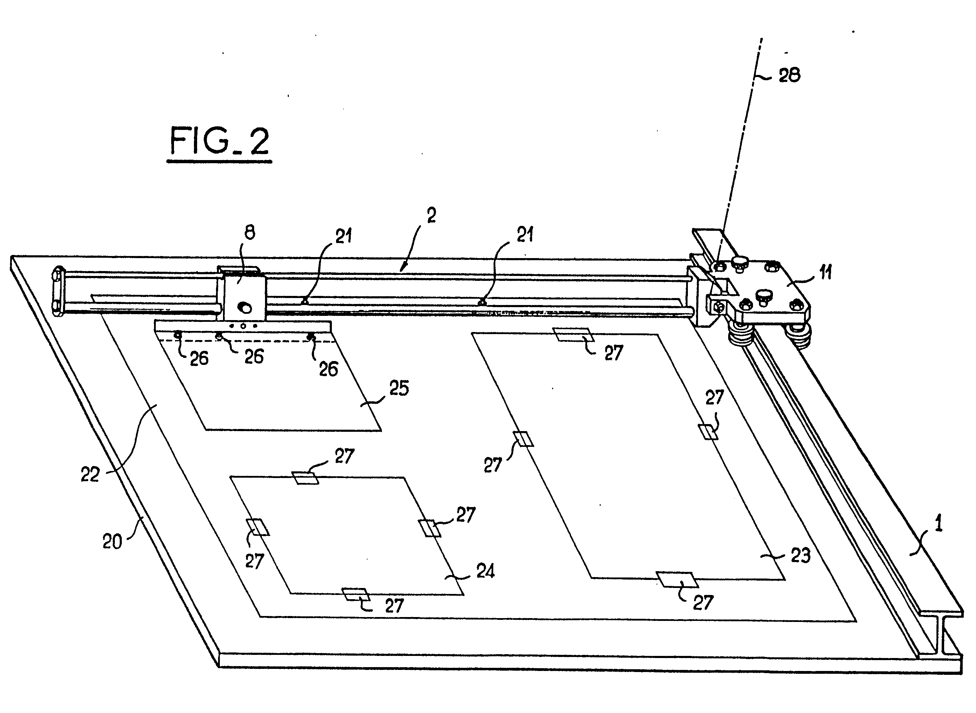

La figure 2 représente une table de montage de sélections de couleur, perfectionnée par l'adjonction du dispositif de la figure 1. Des goujons 21 sont fixés sur la table 20, qui peut être une table lumineuse à succion. La succion permet de maintenir un support à plat sur la table. Ces goujons 21 sont destinés à passer dans des perforations correspondantes formées dans les supports de montage, lorsqu'on place un tel support sur la table. Les supports qui sont ainsi successivement installés sur la table occupent alors une même position, précisément définie par ces goujons, du fait qu'ils ont été préalablement perforés en repérage.

Le dispositif suivant l'invention est placé sur la table 20 de manière que son rail 1 s'appuie sur la table, à proximité du bord droit de celle-ci (du point de vue de la figure 2). Le rail 1 est fixé à la table 20 par des moyens (non représentés) qui peuvent prendre diverses formes bien connues.

Il est clair sur la figure 2 que l'opérateur peut amener la barrette de repérage 13 dans une position quelconque sur un support 22 fixé sur la table, en faisant coulisser le bloc 8 sur ses barres de guidage et en déplaçant la pièce mobile 11 sur son rail 1.

Le procédé suivant l'invention va maintenant être illustré par la description de sa mise en oeuvre lors d'un montage dit "positif" dans la technique de l'impression quadrichromique. Il s'agit alors de réaliser un jeu de quatre planches constituées chacune d'un support de montage et d'un groupe de positifs de sélection. Ces planches sont utilisées ensuite pour fabriquer, par voie photographique, les clichés d'impression qui servent à l'encrage, en repérage, d'une feuille de papier avec des encres de diverses couleurs. Ces quatre planches comprennent respectivement les positifs de sélection "bleu-vert", "magenta", "jaune" et "noir".

On a représenté, sur la figure 2, un support de montage 22 qui porte trois positifs de sélection 23, 24, 25, correspondant à la sélection "magenta" par exemple. Le support est transparent et la mise en place de ces positifs est guidée par une feuille de maquette (non représentée) placée sous le support transparent. Le positif "magenta" 25 fait partie d'un jeu de quatre positifs, correspondant à une même image originale (les autres positifs correspondant aux sélections "jaune", "bleu-vert" et "noir"), venus de l'exposition à · cette image, et à travers des filtres appropriés, de quatre plan-films de même format. Ces plan-films portent, près d'un bord, des perforations au pas des goujons de la barrette 13. De telles perforations peuvent être réalisées avec une perforatrice Kodak Arts Graphiques, Modèle 3, numéro de catalogue 2115-V, vendue en France par la demanderesse. Ces perforations occupent rigoureusement la même position, dans l'appareil de prise de vues utilisé pour l'exposition de ces plan-films. On est ainsi assuré que les quatre positifs de sélection, obtenus après exposition et développement, portent des images parfaitement repérées par rapport à ces perforations, ainsi que les unes par rapport aux autres.

Supposé maintenant que, grâce à la maquette, l'opérateur ait placé le positif de sélection magenta 25 sur la plage du support où il doit être fixé, le bras 2 du dispositif étant relevé dans la position repérée par l'axe 28 _____ sur la figure 2. L'opérateur saisit alors ce bras et le rabat sur la table 20 en le faisant pivoter autour de l'axe d'articulation 9. Il fait glisser ensuite le bloc 8 sur les barres de guidage et rouler la pièce mobile 11 sur son rail, jusqu'à ce que les goujons 14 de la barrette 13 viennent approximativement au-dessus des perforations du positif 25 placé dans la position définie par la maquette sous-jacente. L'opérateur fait passer ensuite l'aile horizontale de la barrette 13 sous le bord du positif près duquel sont formées les perforations, pour passer les goujons de cette barrette dans ces perforations. Il corrige ensuite la position du positif et de la barrette ainsi rendus solidaires, de manière qu'elle coincide avec la position définie par la maquette. L'opérateur serre ensuite les molettes 16 et 18. A l'aide de morceaux de ruban adhésif tels que les morceaux 27, il fixe le positif 25 sur le support de montage et il dégage la barrette du positif en soulevant le bord de ce positif qui est en prise avec cette barrette. Il relève enfin le bras 2 qui s'arrête dans la position repérée par l'axe 28 sur la figure 2, à 100 degrés environ de sa position horizontale.

L'opérateur retire alors le support de montage 22 et lui substitue un autre support destiné, par exemple, à recevoir les divers positifs de sélection "jaune". Il passe les goujons 21 dans les perforations de ce nouveau support. L'opérateur rabat alors le bras 2 sur le support. Du fait du blocage établi par les molettes 16 et 18, les goujons 14 de la barrette 13 retombent alors, sur le support, exactement dans la position qu'ils occupaient sur le support précédent. L'opérateur passe sur ces goujons les perforations du positif de sélection "jaune" qui fait partie du même jeu que le positif "magenta" 25 utilisé précédemment. Ce positif de sélection "jaune" peut être aussitôt fixé sur le support, sans qu'aucun tâtonnement n'ait retardé sa mise en place.

Il est clair que le bras 2 fonctionne en "mémoire mécanique" pour "retenir" la position occupée sur un support par les trois goujons 14 de la barrette 13, de manière à pouvoir matérialiser ensuite cette position sur un autre support substitué au précédent. Dans l'exemple décrit, l'opérateur est ainsi assuré de placer le positif de sélection "jaune", par rapport aux perforations de son support de montage, exactement dans la position occupée par le positif "magenta" 25 par rapport aux perforations de son propre support. Le positif de sélection "jaune" est ensuite fixé sur son support, à l'aide de morceaux de ruban adhésif. Les opérations précédentes sont répétées avec les positifs de sélection "bleu-vert" et "noir" qui font parties du même jeu que les positifs "magenta" et "jaune" précédents. Les jeux de positifs dont font parties les positifs 23 et 24 "magenta" sont mis en place, suivant le même procédé, sur leurs supports respectifs.

A la fin de ces opérations, on dispose de quatre planches portant respectivement les positifs de sélection "bleu-vert", "magenta", "jaune" et "noir". Ces quatre planches de positifs sont parfaitement superposables. Elles servent ensuite à la réalisation des plaques d'impression qui seront utilisées dans une presse à imprimer.

On a vérifié que le procédé de montage suivant l'invention permet d'économiser environ 60% du temps requis par un montage purement manuel, dans le cas d'un montage "positif" du type décrit ci-dessus. Pour un montage "négatif" ——————————————————————————————————————————— (les supports de montage sont alors opaques et sont munis de fenêtres destinées à recevoir les sélections de couleur) l'économie peut atteindre 70%. Le procédé suivant l'invention permet aussi de gagner du temps par rapport au procédé décrit dans le brevet français 1 472 090 précité, essentiellement du fait qu'il n'exige pas la réalisation de perforations sur la table de montage. En outre, le dispositif suivant l'invention, qui est beaucoup plus simple que ceux décrits dans les brevets français 1 472 090 et 2 196 089 précités, peut être réalisé pour un prix très inférieur.

On a décrit l'invention dans sa mise en oeuvre en impression quadrichromique, lors d'un montage "positif". Cependant, il est clair pour l'homme de métier que le procédé de montage suivant l'invention trouve des applications variées en reproduction photomécanique, monochrome ou polychrome, aussi bien que dans toute autre technique faisant appel à des mises en repérage de produits en feuilles.

Enfin, diverses modifications pourraient être apportées au dispositif décrit, sans que l'on sorte du cadre de l'invention. Par exemple, on peut équiper ce dispositif de plusieurs bras identiques au bras 2. Ces bras, mobiles sur un ou plusieurs rails analogues au rail 1, permettent de repérer plusieurs sélections à la fois, sur un même support de montage. La durée du montage s'en trouve raccourcie d'autant.

- 1 -

REVENDICATIONS

1. Procédé de montage des sélections de couleur utilisées en reproduction photomécanique, suivant lequel on monte chacune des sélections d'au moins un jeu de telles sélections sur un des supports de montage d'un jeu de tels supports, de manière que les sélections du jeu occupent sur leurs supports respectifs des positions relatives identiques, caractérisé en ce qu'on place une sélection sur un support, on relève avec _____précision la position de cette sélection sur ce support à l'aide d'un organe de repérage, on remplace le support par un autre qu'on fixe avec précision dans la position occupée par le précédent, on matérialise sur cet autre support la position relevée, grâce à cet organe, et on monte une autre sélection du même jeu sur ce support, dans la position matérialisée par l'organe de repérage.

2. Procédé conforme à la revendication 1, caractérisé en ce qu'on fixe chaque support de montage dans une position précisément définie en faisant passer des goujons solidaires d'une table de montage, dans des perforations complémentaires préalablement percées en repérage dans chacun des supports de montage du jeu de ces supports.

3. Procédé conforme à l'une quelconque des revendications 1 et 2, caractérisé en ce qu'on relève la position d'une sélection sur un support de montage en faisant passer des goujons solidaires de l'organe de repérage dans des perforations préalablement formées dans la sélection de manière que toutes les sélections d'un même jeu soient parfaitement repérées par rapport à leurs perforations, ainsi que les unes par rapport aux autres.

4. Dispositif pour la mise en oeuvre du procédé conforme à l'une quelconque des revendications 1 à 3, caractérisé en ce qu'il comprend (1) au moins un organe de repérage conçu pour coopérer avec une sélection de couleur de manière à repérer sa position et (2) un mécanisme pour supporter cet organe avec deux degrés de liberté dans le plan d'un support de montage propre à recevoir la sélection et pour conserver la position de l'organe de repérage lorsque celui-ci coopère avec une sélection de couleur.

5. Dispositif conforme à la revendication 4, caractérisé en ce qu'il comprend en outre une table munie de moyens propres à retenir un support de montage dans une position prédéterminée sur cette table.

6. Dispositif conforme à la revendication 5, conçu pour recevoir des supports de montage et des jeux de sélections de couleur munis de perforations de repérage , caractérisé en ce que la table et l'organe de repérage portent des goujons complémentaires des perforations des supports de montage et des sélections de couleur, respectivement, pour coopérer avec ces perforations lors du montage d'une sélection sur un support.

7. Dispositif conforme à l'une quelconque des revendications 4 à 6, caractérisé en ce que le mécanisme comprend (a) un rail fixé à la table, (b) une pièce mobile sur ce rail et (c) un bras articulé sur cette pièce mobile dans un plan perpendiculaire au rail, ce bras supportant à coulissement un bloc qui porte lui-même l'organe de repérage.

8. Dispositif conforme à la revendication 7, caractérisé en ce qu'il comprend des molettes de blocage pour immobiliser, d'une part, le bloc sur le bras et, d'autre part, la pièce mobile sur le rail.

9. Dispositif conforme à l'une quelconque des revendications 7 et 8, caractérisé en ce que le bras est articulé sur la pièce mobile par l'intermédiaire d'une embase pivotante qui rend le bras mobile entre une première position où il repose sur la table et une deuxième position où il est écarté de cette table.

10. Dispositif conforme à l'une quelconque des revendications 4 à 9, caractérisé en ce qu'il comprend plusieurs organes de repérage et autant de mécanismes pour supporter ces organes avec deux degrés de liberté dans le plan d'un même support de montage.

11. Dispositif conforme à la revendication 5, caractérisé en ce que la table est lumineuse.

12. Dispositif conforme à l'une quelconque des revendications 5 et 11, caractérisé en ce que la table comprend des moyens de succion propres à maintenir un support à plat sur cette table.

FIG_1

7 3 2 18 11 18 6 8 5 16 10 9 12 12 15' 15' 13 14 14 15 14 1 7 4

1/2

0007328

FIG_2

0007328

**Office européen des brevets**

**RAPPORT DE RECHERCHE EUROPEENNE**

Numéro de la demande

**EP 78 40 0066**

| | DOCUMENTS CONSIDERES COMME PERTINENTS | | CLASSEMENT DE LA DEMANDE (Int. Cl.²) |
|---|---|---|---|
| Catégorie | Citation du document avec indication, en cas de besoin, des parties pertinentes | Revendica-tion concernée | |
| X | <u>DE - A - 2 052 209</u> (MISOMEX)  * Page 2, ligne 23 - page 4, ligne 21; page 5, lignes 17 - 30; page 7, ligne 13 - page 9, ligne 6; les figures; les revendications *  -- | 1-6,9, 10-12 | G 03 F 9/00 |
| | <u>DE - A - 2 351 220</u> (BAPTIST BACHER)  * Page 4, ligne 16 - page 5, ligne 25; page 7, lignes 6-17; page 8, ligne 4 - page 10, ligne 1; page 12, lignes 1-9; page 14, ligne 8 - page 15, ligne 24; page 19, ligne 20 - page 21, ligne 7; page 22, lignes 8-23; les reven-dications; les figures *  -- | 1-12 | DOMAINES TECHNIQUES RECHERCHES (Int. Cl.²)  G 03 F 9/00 |
| | <u>US - A - 4 018 528</u> (R.J. DENNIS)  '* Les revendications; les fi-gures *  -- | 1-3 | |
| | <u>DE - A - 2 420 447</u> (INONE YOSHIO)  * Les revendications; les fi-gures *  -- | 1-7,10, 12 | CATEGORIE DES DOCUMENTS CITES  X: particulièrement pertinent |
| | <u>GB - A - 264 948</u> (G.H. WALTERS)  * Les revendications; les fi-gures *  -- | 7,8 | A: arrière-plan technologique  O: divulgation non-écrite  P: document intercalaire  T: théorie ou principe à la base de l'invention  E: demande faisant interférence  D: document cité dans la demande  L: document cité pour d'autres raisons |
| | <u>US - A - 3 104 475</u> (R. BOEIJINGA)  ./. | 7,8 | |

&: membre de la même famille, document correspondant

Le présent rapport de recherche a été établi pour toutes les revendications

| Lieu de la recherche | Date d'achèvement de la recherche | Examinateur |
|---|---|---|
| La Haye | 29-03-1979 | RASSCHAERT |

OEB Form 1503.1 06.78

**Office européen des brevets**

## RAPPORT DE RECHERCHE EUROPEENNE

| Catégorie | Citation du document avec indication, en cas de besoin, des parties pertinentes | Revendication concernée | CLASSEMENT DE LA DEMANDE (Int. Cl.²) |
|---|---|---|---|
| | **DOCUMENTS CONSIDERES COMME PERTINENTS** | | |
| | * Les revendications; les figures * | | |
| | -- | | |
| | GB - A - 289 914 (J.A. COREY) | 7,8,9 | |
| | * Page 9, lignes 101-126; la figure, les revendications * | | |
| | -- | | |
| A | FR - A - 2 127 964 (YOSHIO INONE) | 1,6 | **DOMAINES TECHNIQUES RECHERCHES (Int. Cl.²)** |
| | * Figure 9; les revendications * | | |
| | -- | | |
| A | US - A - 2 223 505 (E.B. BECCARD) | 1 | |
| | * Les figures * | | |
| | ---- | | |

OEB Form 1503.2   06.78